Europäisches Patentamt

European Patent Office

Office européen des brevets

(19)

(11) **EP 0 520 125 B1**

(12) **EUROPEAN PATENT SPECIFICATION**

(45) Date of publication and mention
of the grant of the patent:
**20.08.1997   Bulletin 1997/34**

(51) Int Cl.⁶: **H03K 17/62**

(21) Application number: **91830287.8**

(22) Date of filing: **27.06.1991**

(54) **Switching circuit for connecting a first circuit node to a second or to a third circuit node according to the latter's potential, for controlling the potential of an insulation region of an integrated circuit according to the substrate's potential**

Schaltkreis zum Verbinden eines ersten Knotens mit einem zweiten oder dritten Knoten in Abhängigkeit vom Potential des letzteren, zum Steuern des Potentials eines Isolationsbereiches in einer integrierten Schaltung in Abhängigkeit der Substratspannung

Circuit de commutation pour connecter une première borne à une seconde ou troisième borne en fonction du potentiel de cette dernière, pour commander le potentiel de la région d'isolation d'un circuit intégré en fonction du potentiel du substrat

(84) Designated Contracting States:
**DE FR GB IT**

(43) Date of publication of application:
**30.12.1992   Bulletin 1992/53**

(73) Proprietor: **CONSORZIO PER LA RICERCA SULLA MICROELETTRONICA NEL MEZZOGIORNO 95121 Catania (IT)**

(72) Inventors:
• **Aiello, Natale**
  **I-95123 Catania (IT)**

• **Palara, Sergio**
  **I-95021 Acicastello (Catania) (IT)**

(74) Representative: **Mittler, Enrico et al
c/o Mittler & C. s.r.l.,
Viale Lombardia, 20
20131 Milano (IT)**

(56) References cited:
**EP-A- 0 357 528        EP-A- 0 432 058
DE-A- 2 148 747        DE-A- 2 929 515
US-A- 4 471 237**

## Description

The present invention relates to a switching circuit for connecting a first circuit node to a second or to a third circuit node according to the latter's potential, for controlling the potential of an insulation region of an integrated circuit in relation to the substrate's potential.

Let us consider a circuit in which there is a control device for driving a power device, such as an NPN transistor or darlington, for a resonant load present on its collector.

When the control device executes the switching operations, the potential on the collector of the power device assumes negative values.

In the case wherein the circuit is hybrid, that is with a power device physically insulated from the integrated circuit which accomplishes the control device, this fact does not represent a problem, but it is extremely harmful in the case wherein the control device and the power device are integrated on the same silicon chip accomplishing a vertical-type structure.

Under normal operating conditions the insulation region (or "p-well" region) of the part of the integrated circuit accomplishing the control device is connected to the lowest potential available, in practice to ground.

During the operation of the power device, its collector, which in the integrated embodiment coincides with the substrate of the integrated circuit, is at a positive voltage and the parasitic transistors which are formed in the integrated structure are interdicted.

If for any reason, such as, say, when the control device executes the switching operations, the substrate goes below ground for a value higher than the conduction threshold, the parasitic transistors go into conduction and drain current away from the control device. This fact causes a malfunction both of the control device and of the power device.

To eliminate this drawback it is in theory sufficient to connect the insulation region of the power device to a negative voltage equal to the maximum less-than-ground value reacheable by the substrate, but sources of negative power are not always available in the integrated circuit, as the lowest potential is normally that of ground, constituted by the casing.

A circuit which allows the elimination of this drawback is described in EP-A-0 432 058, which claims the priority of the patent application No. 89/16144 filed in France on 29 November 1989 in the name of SGS-THOMSON MICROELECTRONICS S.A. et SIEMENS AUTOMOTIVE S.A.

There is described in this application a dynamic insulation circuit of integrated circuits.

This circuit provides that in an integrated circuit of the type illustrated above, that is, comprising a control device driving a power device for a resonant load, use be made of MOS devices for the accomplishment of a first stage suitable for generating a first voltage level in relation to the value of the voltage assumed by the integrated circuit's substrate and of a second stage which comprises a first and a second transistor with the function of a switch suitable for connecting the insulation region to ground or to the substrate, respectively, in relation to the values of voltage assumed by the substrate itself.

This circuit, however, is very complicated due to the large number of circuit components required and for the manner in which the conduction of the second transistor is obtained. The switching threshold of the second transistor with a switching function is, moreover, obtained in relation of the substrate's voltage.

The object of the present invention is to eliminate the above mentioned drawback through a switching circuit which should be especially simple as regards both the structure of the circuit and the number of components required and which is suitable for connecting the insulation region of the control device alternately to the substrate and to ground, for a negative and positive substrate voltage, respectively.

The more general object of the present invention is to accomplish a switching circuit for connecting a first circuit node to a second or to a third circuit node according to the latter's potential.

According to the invention such objects are attained by means of a switching circuit as defined in claim 1.

It is thus possible to solve the problem mentioned above linked with the accomplishment of a power device for a resonant load and of the corresponding control device in a single integrated structure of the vertical type.

The features of the present invention shall be made more evident by the embodiments illustrated as a non-limiting example in the enclosed drawings, wherein:

Fig. 1 illustrates a first circuit embodiment of the switching circuit according to the present invention;
Fig. 2 illustrates a second circuit embodiment of the circuit according to the present invention;
Fig. 3 illustrates a first improvement of the first circuit embodiment illustrated in Fig. 1;
Fig. 4 illustrates a first improvement of the second circuit embodiment illustrated in Fig. 2;
Fig. 5 illustrates a second improvement of the first circuit embodiment illustrated in Fig. 1;
Fig. 6 illustrates a second improvement of the second circuit embodiment illustrated in Fig. 2;
Fig.s 7 and 8 illustrate adjacent parts of an integrated circuit comprising on a single silicon chip a power device, a control device and a switching circuit according to the embodiment of Fig. 1;
Fig. 9 illustrates an embodiment alternative to that illustrated in Fig. 8;
Fig. 10 illustrates the embodiment in the integrated form of the switching circuit illustrated in Fig. 2 and of the power device.

The description which follows is in relation to an integrated circuit comprising a power device, such as a power transistor or darlington, for a resonant load applied to its collector, a control device for said power device and a switching circuit according to the present invention.

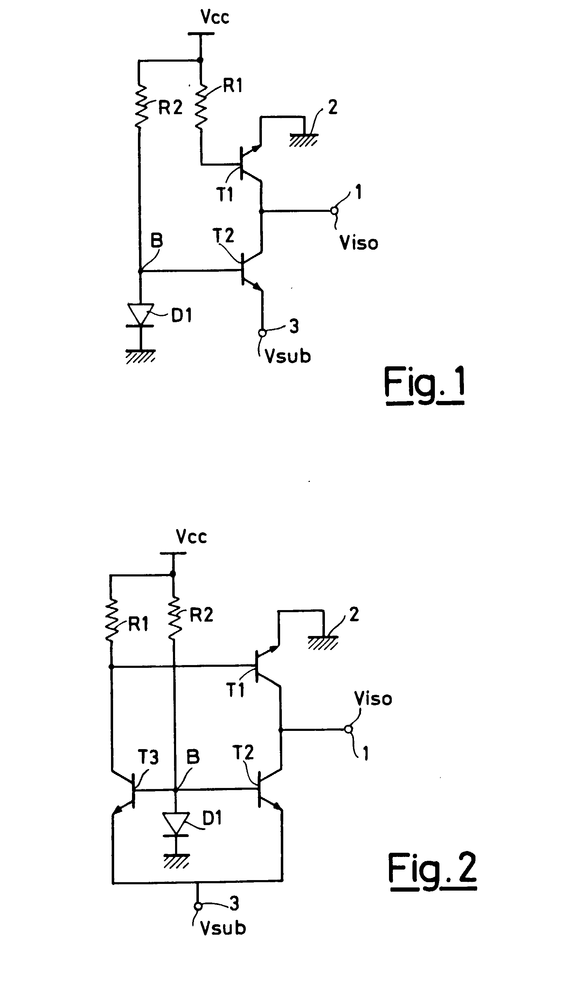

According to a first embodiment, illustrated in Fig. 1, the switching circuit according to the invention comprises a first bipolar transistor T1 of the NPN type with the function of a switch with the collector connected to a first circuit node 1 at a voltage Viso, say, constituted by an insulation region of the integrated circuit which contains the power device's control device, the emitter connected to a second circuit node 2 at the ground voltage and the base connected through a resistance R1 to a power supply Vcc.

The circuit also provides for a second bipolar transistor T2 of the NPN type with the function of a switch with the collector connected to the voltage Viso, the emitter connected to a third circuit node 3 at the voltage Vsub, say, constituted by the substrate of the integrated circuit, coincident with the power device's collector, and the base connected, on one side to the power supply Vcc through a resistance R2, on the other side to ground through a base bias diode D1, which maintains the base of transistor T2 at a pre-set constant voltage, say, equal to +1Vbe (base-emitter voltage of the transistor T2).

When the voltage Vsub across the third circuit node 3 and thus across the substrate of the integrated circuit is higher than zero, the transistor T1 is in saturation and connects, at less than the Vcesat (T1) (collector-emitter saturation voltage of the transistor T1), the first circuit node 1 and thus the insulation region of the integrated circuit to the second circuit node 2 and thus to the circuit's ground.

But the transistor T2 is in the interdiction state since by means of the diode D1 the potential of the base of transistor T2 has been fixed at +1Vbe, that is, to be able to enter into conduction the second transistor T2 must have at least +1Vbe between base and emitter.

When the substrate voltage is less than or equal to zero, the transistor T2 goes into saturation, since its base is always at +1Vbe. This has the object of bringing the circuit node 1, that is, the insulation region of the integrated circuit, to the same potential Vsub of the circuit node 3, that is, of the substrate, naturally at less than Vcesat (T2).

As a consequence the collector of the transistor T1 is at potential that is lower than that of its emitter, so that the transistor T1 is reverse biased.

Also, since the gain of a reverse biased transistor, of the order of units, is far less than that of of a directly biased transistor, of the order of hundreds of units, the current required in the circuit node 1, that is, in the insulation region of the integrated circuit, on the part of the transistor T1 is without any doubt negligible with respect to the current which the transistor T2 drains from the circuit node 1 towards the circuit node 3, that is, from the insulation region towards the substrate, so that the transistor T1 behaves with a good approximation like an open circuit.

The circuit of Fig. 2 represents a second embodiment of a switching circuit according to the invention. This differs from that of the first embodiment, represented in Fig. 1, for the addition of a third transistor T3 with base and emitter connected to the base and to the emitter of the transistor T2, respectively, and with the collector connected to the base of the transistor T1 and through the resistance R1 to the supply voltage Vcc.

Analysing its operation, still with reference to an integrated circuit as described above, when the substrate voltage Vsub is higher than zero, the second and third transistors T2 and T3 are interdicted since their base, as for the circuit of Fig. 1, is linked to the potential +1Vbe by the presence of the diode D1 connected to their base.

The interdiction of the transistor T3 thus implies the saturation of the transistor T1, whose base voltage is equal to the difference between the supply voltage Vcc and the voltage across the resistance R1, with the consequent linking of the insulation region to the ground of the circuit.

When the substrate voltage Vsub is Less than or equal to zero, the transistors T1 and T2 go to saturation, since their base is always at +1Vbe. The saturation of the transistor T2 thus implies the consequent linking of the insulation region to the same potential of the substrate.

The saturation of the transistor T3 lowers the potential of the base voltage of the transistor T1 to values that are lower than or equal to zero, so that the transistor T1 is interdicted.

Of the two circuits, that of Fig. 1 is faster in action than that of Fig. 2, since the transistor T1 is always in conduction, while that of Fig. 2 has the advantage of a more decisive interdiction of the transistor T1.

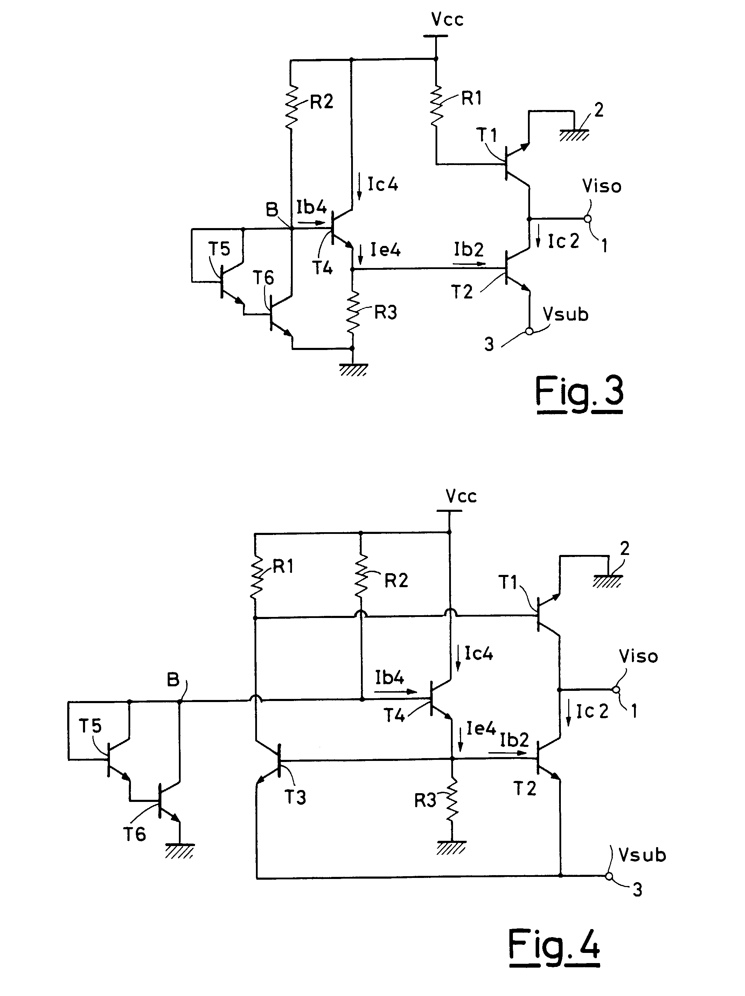

For reasons of a technological character the circuits of Fig. 1, 2 have been modified to those of Fig. 3, 4, respectively.

The circuit of Fig. 3 which is the modified version of that of Fig. 1, differs from the latter only in the introduction of transistors T4, T5, T6 and of a resistance R3.

The transistor T4 has the collector connected to the power supply Vcc, the emitter connected to the base of the transistor T2 and through the resistance R3 to ground. The base of transistor T4 is connected through a resistance R2 to the power supply Vcc. At the base of transistor T4, at a circuit node B, there are connected the collectors of the two transistors T5, T6. The collector of transistor T5 is connected to the base of the same, the emitter is connected to the base of the transistor T6. The emitter of the transistor T6 is grounded.

Similarly the circuit of Fig. 4, which is the modified version of that of Fig. 2, differs from the latter only in the introduction of the same transistors T4, T5, T6, and of the resistance R3, inserted into the circuit and connected in a manner altogether similar to that already illustrated in Fig. 3.

The reasons for accomplishing the changes introduced into the circuits of Fig.s 3 and 4 are as follows.

During the quenching of the power device, the voltage across its collector, and thus the substrate voltage Vsub of the integrated circuit, can reach 400-500 volts. Under these conditions the transistor T2 which is open and acts as a sensor for the state of the substrate, must be accomplished with a structure such as to endure these high voltages presenting an reverse voltage Vbe (T2) greater than 500 VOLTS.

As shall be explained better later with reference to Fig.s 8, 9 and 10, which represent embodiments in the integrated form of the circuits of Fig.s 1, 2, the transistor T2 is accomplished outside the insulation region of the integrated circuit and has a very low current gain (equal to 2) so that it is necessary to drive it with the transistor T4.

We have:

$$Ic2 = hfe2 * Ib2$$

where $Ib2 \approx Ie4$ is approximately equal to hfe4*Ib4 and substituting

$$Ic2 = hfe2 * hfe4 * Ib4$$

where Ic is the collector current of the transistor T2, Ib2 is the base current of the transistor T2, Ie4 is the emitter current of the transistor T4. In addition, hfe2 and hfe4 are the current gains of the transistors T2 and T4.

The transistors T5 and T6 have been inserted in place of the diode D1 so as to continue to maintain the circuit's switching threshold at about 0 volts.

Since the transistor T2 operates with a Vbe of about 0.5 volts, the potential of the node B is of 1.2 volts; as a consequence it has not been possible to use two diodes connected in series which would have given a potential of 1.4 volts at the node B.

It could also be possible to use a voltage multiplier constituted by a transistor with the collector connected to the node B, the emitter connected to ground and the base connected to the intermediate node between the resistances placed in series and connected at the other extremity to the node B and to ground, respectively.

This multiplier, however, suffers from the drawback of taking up an area that is greater than that taken up by the two transistors T5, T6. Utilizing for the circuits of Fig. 3, 4 the two transistors in cascade T5, T6, of which the first is diode connected, a value of the voltage of the point B of some 1.28 has been obtained.

This voltage is the sum of the Vbe of the transistor T5, equal to 0.7 volts, and of the Vbe of the transistor T6, equal to some 0.58 volts. The Vbe of the transistor T6 is different from 0.7 volts, since, as the transistor T6 has not been diode connected, its Vbe is in relation to the collector current.

A further way of accomplishing the circuit of Fig. 3 is that of introducing in place of the resistance R3, connected between the emitter of the transistor T4 and ground, a diode D2 with corresponding series resistance, in series with a small resistance R4 with a value equal to about 10 Ohms with the object of limiting the current Ic4.

The corresponding circuit solutions starting with the circuits illustrated in Fig.s 3, 4 are illustrated in Fig.s 5, 6, respectively.

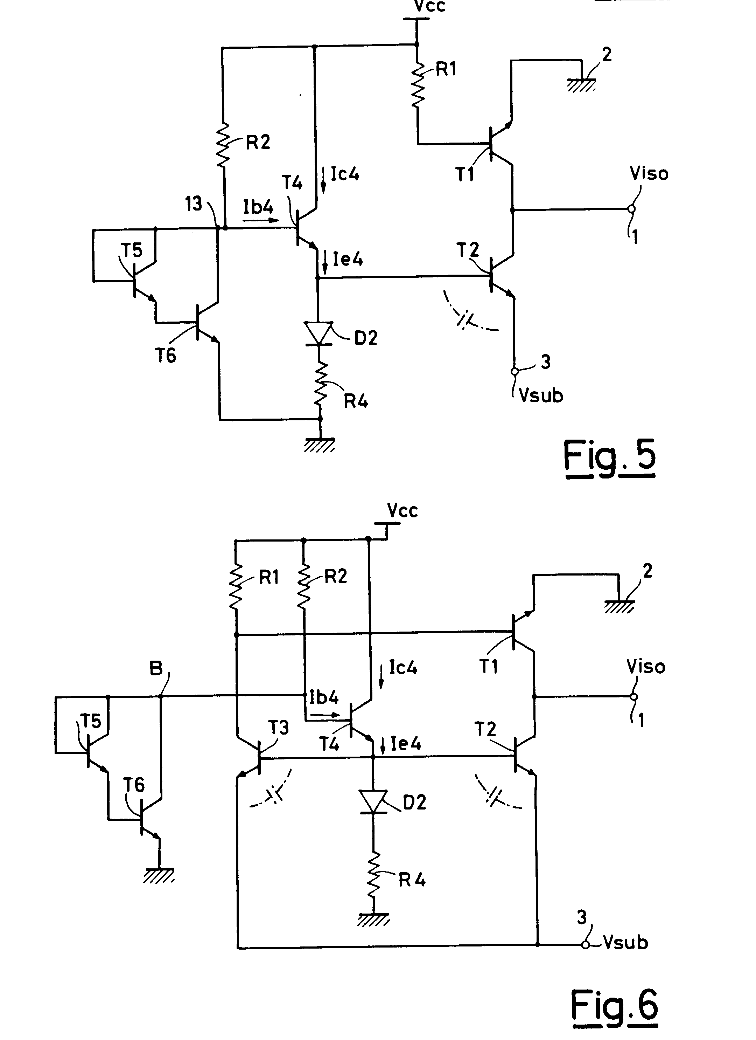

The introduction of this modification improves the performance of the circuit since it allows the discharge of the emitter-base capacity of the transistor T2, in the circuit of Fig. 5, and those of transistors T2, T3, in the circuit of Fig. 6, indicated in both circuits with a dotted line, to ground and not in the insulation region, as is the case in the previous versions. This fact would in fact involve the rise of the voltage Viso beyond the limit imposed by the saturation of the transistor T1.

The operation of the circuits of Fig.s 5, 6 can be analysed as follows.

When the substrate voltage Vsub is less than zero, the second transistor T2 goes to saturation, taking its base to a negative potential; as a consequence the diode D2 is interdicted. In this case, with respect to the case of the circuit of Fig. 3, wherein there is only the resistance R3 on the emitter of the transistor T4, there is a further advantage during the stage of conduction of T2, since there is no dispersion of current to ground through R3.

And when the substrate goes to a potential that is higher than or equal to zero, the diode 2 starts conducting and allows the discharge of the capacity between the base and the emitter of the transistor T2 in the case of Fig. 5 (of the capacity between the base and the emitter of the transistors T2 and T3 in the case of Fig. 6) to ground with a fairly small time constant imposed by the value of the series of resistances R4 and of the series resistance of the diode D2.

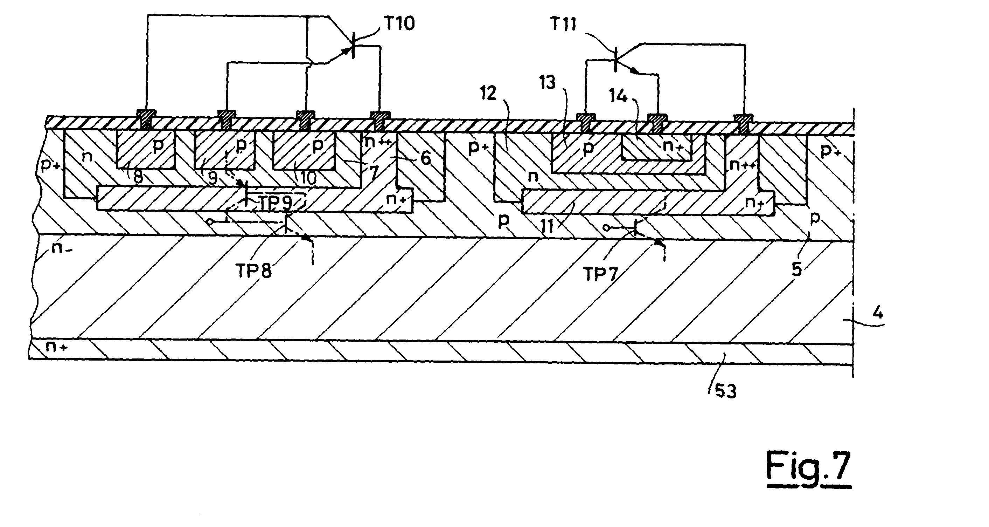

If we now go to the embodiments in the form of integrated circuits, Fig. 7 should be considered aligned from the left to one or the other of Fig.s 8 ,9, putting the sides indicated with a dotted line side by side.

With reference to Fig.s 7, 8, on a substrate 53 of the type n+, which represents the collector of the power device, there is superimposed an epitaxial layer 4 of the type n-. Inside the epitaxial layer 4 of the type n- there is an insulation region 5 of the type p, called p-well region.

With reference to Fig. 7, inside the region 5 there is a region 6 of the type n+ suitable for constituting the base of a lateral transistor T10 of the type PNP. Inside the region 6 there is a region 7 of the type n and inside this regions 8, 10 of the type p suitable for constituting the collector of the laterial transistor and a region 9 of the type p suitable for constituting the emitter of the same lateral transistor.

Again with reference to Fig. 7, inside the region 5 there is a region 11 of the type n+ suitable for constituting the collector of a vertical transistor T11 of the type NPN. Inside the region 11 there is a region 12 of the type n and inside this there is a region 13 of the type p suitable for constituting the base of the vertical transistor T11. Inside the region 13 there is a region 14 of the type n+ suitable for constituting the emitter of the vertical transistor.

The lateral transistor T10 of the type PNP and the vertical transistor T11 of the type NPN together constitute the power device's control device.

The region 5 also represents the base region of a first parasitic transistor TP7 with collector represented by the region 11 and emitter represented by the region 4 and of a second parasitic transistor TP8 in an SCR configuration with a third parasitic transistor TP9. The emitter of the parasitic transistor TP8 is represented by the region 4, the collector of the parasitic transistor TP8 is represented by the region 6 and connected to the base of the parasitic transistor TP9, the collector of the parasitic transistor TP9 is connected to the base of the parasitic transistor TP8, the emitter of the parasitic transistor TP9 is represented by the region 9.

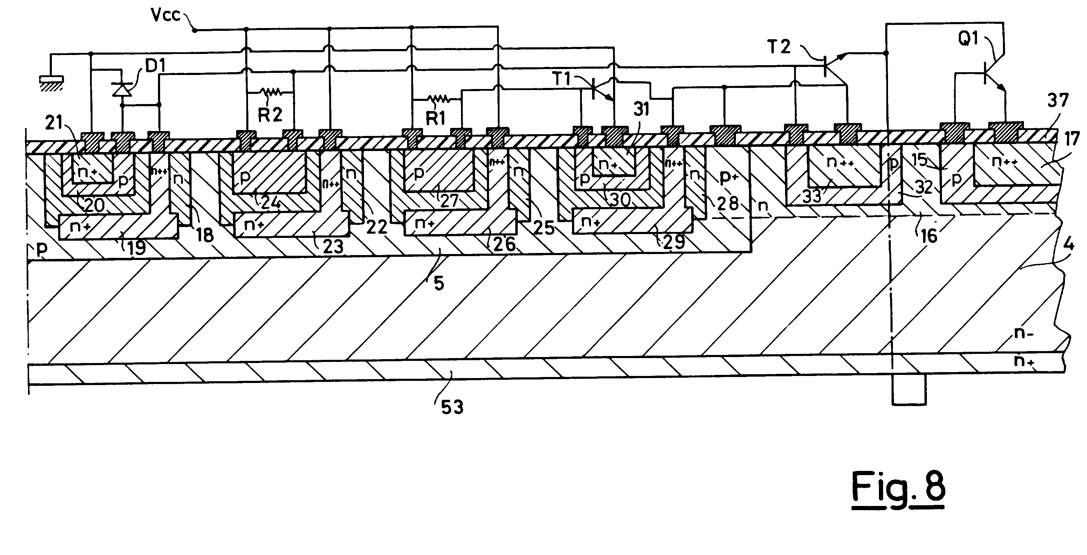

With reference to Fig. 8, which corresponds to the integrated embodiment of the circuit of Fig. 1, in the region 5 there is a region 18 of the type n which contains inside it a region 19 of the type n++ towards the surface of the integrated circuit and of the type n+ in depth and a region 20 of the type p. Inside the region 20 there is a region 21 of the type n+. The regions 20, 21 represent the region p and the region n of the diode D1.

Inside the region 5 there is also a region 22 of the type n and inside this a region 23 of the type n++ towards the surface and of the type n+ in depth. Inside the region 22 there is a region 24 of the type p suitable for constituting the diffuse resistance R2.

Inside the region 5 there is also a region 25 of the type n and inside this a region 26 of the type n++ towards the surface and of the type n+ in depth. Inside the region 25 there is a region 27 of the type p suitable for constituting the diffuse resistance R1.

Inside the region 5 there is also a region 28 of the type n and inside this a region 29 of the type n++ towards the surface and of the type n+ in depth. Inside the region 28 there is a region 30 of the type p and inside this a region 31 of the type n+. The regions 30, 31 and 29 represent the base, emitter and collector, respectively, of the transistor T1.

In an sub-region 16 of the type n of the region 4 there is contained a region 15 of the type p and inside this a region 17 of the type n++ suitable for representing base and emitter, respectively, of the power device Q1. The collector of the power device, as mentioned above, is represented by the substrate 53.

Inside the sub-region 16 there is also a region 32 of the type p and inside this a region 33 of the type n++. The regions 32, 53 and 33 represent the base, emitter and collector, respectively, of the transistor T2.

On the surface of the integrated circuit there is a layer of oxide 37 through which various access contacts to the regions of the integrated circuit are made to pass.

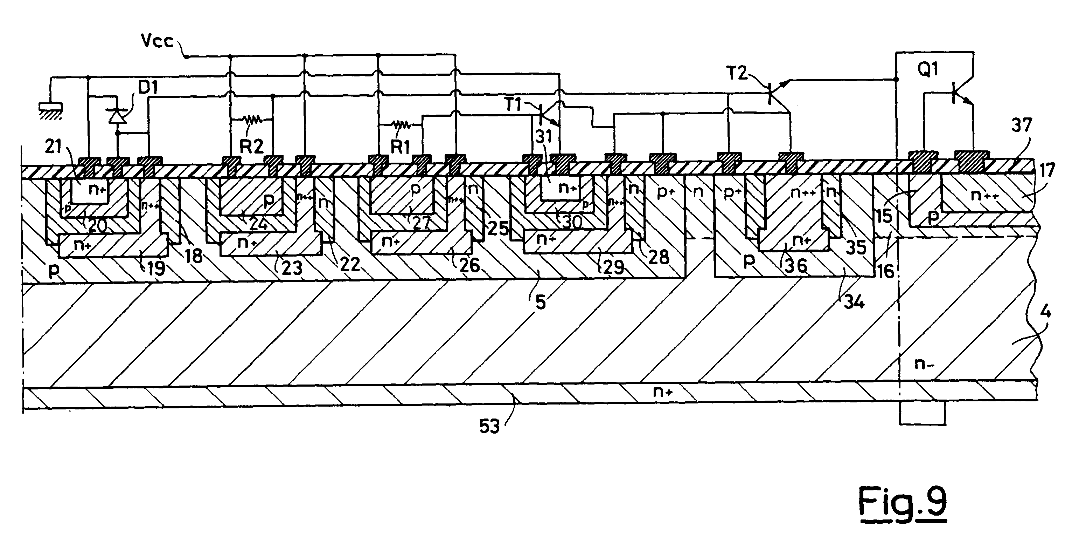

With reference to Fig. 9, this differs from Fig. 8 only for the manner in which the transistor T2 is accomplished.

The base region of the transistor T2 is represented by a region 34 of the type p+ towards the surface and of the type p in depth. Inside the region 34 there is a region 35 of the type n and inside this a region 36 of the type n++ towards the surface and of the type n+ in depth suitable for constituting the collector of the transistor T2. The emitter of the transistor T2 is represented by the substrate 53.

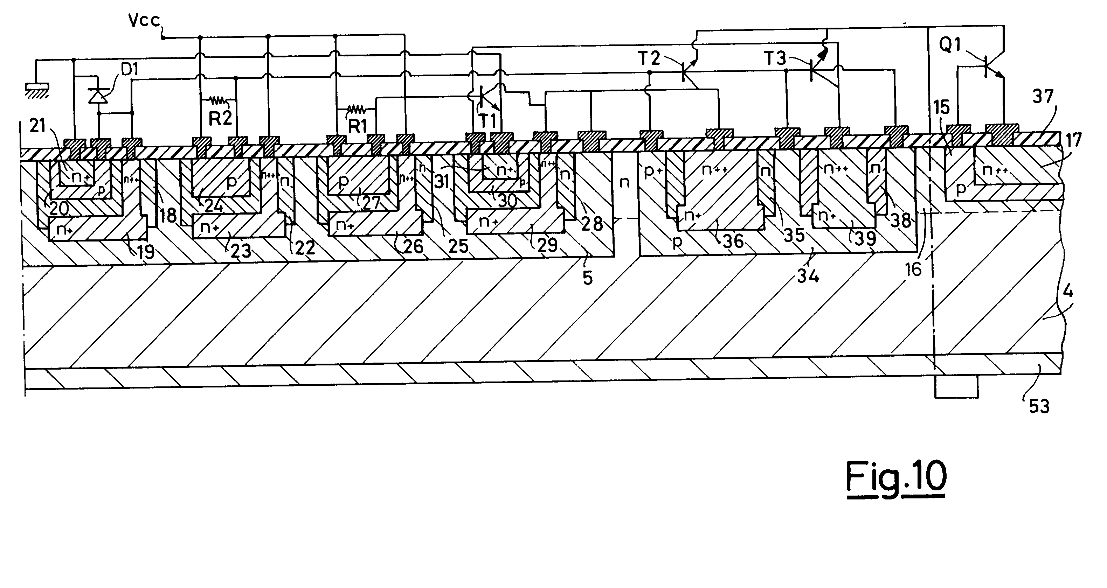

With reference to Fig. 10, this corresponds to the integrated representation of the circuit of Fig. 2 and differs from Fig. 9 due to the presence inside the region 34 of a region 38 of the type n and inside it of a region 39 of the type n++ towards the surface and of the type n+ in depth. The regions 34, 53 and 39 represent the base, collector and semitter, respectively, of the transistor T3.

It should be noted that the presence of the integrated switching circuit in one and the same silicon chip with the control device and the power device causes any lower-than-ground voltages on the collector of the power device during the switching operations of the control device do not cause the conduction of the parasitic transistors TP7, TP8, TP9 of the control device (Fig. 7), always present, and thus avoid damages to or malfunctions of the control device and of the power device itself.

**Claims**

1. Switching circuit for connecting a first circuit node (1) to a second or to a third circuit node (2,3) according to the latter's potential, for controlling the potential of an insulation region of an integrated circuit in relation to the substrate's potential, comprising a first bipolar transistor (T1) of the NPN type with the collector connected to said first node (1) and the emitter connected to said second node (2), a second bipolar transistor (T2) of the NPN type with the collector connected to said first node (1) and the emitter connected to said third node (3), and means (D1, T5, T6) for maintaining the base of said second transistor (T2) at a constant pre-set bias voltage, in which said three circuit nodes (1, 2, 3) form part of an integrated circuit comprising a substrate (53), a power device (Q1) with the collector coinciding with said substrate (53) and constituting said third node (3) and a control device of the power device housed in an insulation region (5) constituting said first node (1), the second node (2) being constituted by a connection to ground, said first and second transistors (T1, T2) of the switching circuit connecting the insulation region (5) of the integrated circuit alternately to the substrate (53) or to ground according to the value of the voltage assumed by the substrate (53) of the integrated circuit and thus by the collector of the power device (Q1).

2. Switching circuit according to claim 1, characterised in that said means (D1, T5, T6) for maintaining the base of said second transistor (T2) at a constant pre-set bias voltage are constituted by diode means (D1) interposed between the base of said second transistor (T2) and ground.

3. Switching circuit according to claim 1, characterised in that the base of said second bipolar transistor (T2) is connected to the emitter of a further bipolar transistor (T4) of the NPN type with the collector connected to a power supply having a voltage (Vcc) and the emitter connected to ground through a resistance (R3), which further transistor (T4) is suitable for driving said second transistor (T2) so as to increase its gain.

4. Switching circuit according to claims 3, characterised in that said means (D1, T5, T6) for maintaining the base of the second transistor (T2) at a constant pre-set bias voltage are constituted by a pair of bipolar transistors (T5, T6) of the NPN type arranged in cascade between the base of said further transistor (T4) and ground, the first of which (T5) is diode connected.

5. Switching circuit according to claim 3, characterised in that said resistance (R3) is replaced by a diode (D2).

6. Switching circuit according to claim 3, characterised in that said resistance (R3) is replaced by the series of a diode (D2) and of a resistance (R4) having a small value.

7. Switching circuit according to claim 1, characterised in that the base of said first transistor (T1) is connected to the collector of a third bipolar transistor (T3) of the NPN type with the emitter connected to the third circuit node (3) and with the base connected to the base of said second transistor (T2), said third transistor (T3) being suitable for entering into saturation when the voltage of the third node (3) is less than or equal to zero lowering the base potential of said first transistor (T1) to values less than or equal to zero and thus interdicting it.

8. Switching circuit according to claim 7, characterised in that said second and third transistors (T2, T3) are implemented so as to endure reverse base/emitter voltages of the order of 500 volts.

**Patentansprüche**

1. Schaltkreis zum Verbinden eines ersten Knotens mit einem zweiten oder dritten Knoten (2, 3) in Abhängigkeit vom Potential des letzteren zum Steuern des Potentiales eines Isolationsbereiches einer integrierten Schaltung in Beziehung zu der Substratspannung, mit

einem ersten Bipolartransistor (T1) des NPN-Tpyes, bei dem der Kollektor mit dem ersten Knoten (1) verbunden ist und der Emitter mit dem zweiten Knoten (2) verbunden ist, einem zweiten Bipolartransistor (T2) des NPN-Types, bei dem der Kollektor mit dem ersten Knoten (1) verbunden ist und der Emitter mit dem dritten Knoten (3) verbunden ist, und einem Mittel (D1, T5, T6) zum Halten der Basis des zweiten Transistors (T2) auf einer konstanten voreingestellten Vorspannung, bei der die drei Knoten (1, 2, 3) Teil einer integrierten Schaltung bilden mit einem Substrat (53), einer Leistungseinrichtung (Q1), bei der der Kollektor mit dem Substrat (53) übereinstimmt und den dritten Knoten (3) darstellt, und einer Steuereinrichtung der Leistungseinrichtung, die in einem Isolationsbereich (5) aufgenommen ist, der den ersten Knoten (1) darstellt, wobei der zweite Knoten (2) durch eine Verbindung mit Masse dargestellt ist, der erste und zweite Transistor (T1, T2) des Schaltkreises den Isolationsbereich (5) der integrierten Schaltung abwechselnd mit dem Substrat (53) oder Masse in Abhängigkeit von Wert der Spannung verbinden, die von dem Substrat (53) der integrierten Schaltung und somit von dem Kollektor der Leistungseinrichtung (Q1) angenommen wird.

2. Schaltkreis nach Anspruch 1, dadurch gekennzeichnet, daß das Mittel (D1, T5, T6) zum Halten der Basis des zweiten Transistors (T2) auf einer konstanten voreingestellten Vorspannung durch ein Diodenmittel (D1) dargestellt ist, das zwischen der Basis des zweiten Transistors (T2) und Masse geschaltet ist.

3. Schaltkreis nach Anspruch 1, dadurch gekennzeichnet, daß die Basis des zweiten Bipolartransistors (T2) mit dem Emitter eines weiteren Bipolartransistors (T4) des NPN-Types verbunden ist, bei dem der Kollektor einer Spannungsversorgung mit einer Spannung (Vcc) verbunden ist und der Emitter mit Masse über einen Widerstand (R3) verbunden ist, wobei der weitere Transistor (D4) geeignet ist zum Treiben des zweiten Transistors (T2) so, daß seine Verstärkung erhöht wird.

**4.** Schaltkreis nach Anspruch 3,
dadurch gekennzeichnet, daß das Mittel (D1, T5, T6) zum Halten der Basis des zweiten Transistors (T2) auf einer konstanten voreingestellten Vorspannung durch ein Paar von bipolaren Transistoren (T5, T6) des NPN-Types dargestellt ist, die in Kaskade zwischen der Basis des weiteren Transistors (T4) und Masse angeordnet sind, wobei der erste davon (T5) diodengeschaltet ist.

**5.** Schaltkreis nach Anspruch 3,
dadurch gekennzeichnet, daß der Widerstand (R3) durch eine Diode (D2) ersetzt ist.

**6.** Schaltkreis nach Anspruch 3,
dadurch gekennzeichnet, daß der Widerstand (R3) durch eine Reihenschaltung einer Diode (D2) und eines Widerstandes (R4) mit einem kleinen Wert ersetzt ist.

**7.** Schaltkreis nach Anspruch 1,
dadurch gekennzeichnet, daß die Basis des ersten Transistors (T1) mit dem Kollektor eines dritten Bipolartransistors (T3) des NPN-Types verbunden ist, bei der der Emitter mit dem dritten Knoten (3) verbunden ist und bei dem die Basis mit der Basis des zweiten Transistors (T2) verbunden ist, wobei der dritte Transistor (T3) geeignet ist zum Eintreten in die Sättigung, wenn die Spannung des dritten Knotens (3) kleiner als oder gleich Null ist, wobei das Basispotential des ersten Transistors (T1) auf Werte kleiner gleich oder gleich Null gesenkt wird und somit dieses verbietet.

**8.** Schaltkreis nach Anspruch 7,
dadurch gekennzeichnet, daß der zweite und dritte Transistor (T2, T3) so eingesetzt sind, daß sie eine Rückwärtsbasis-/Rückwärtsemitterspannung von der Größenordnung von 400 Volt ertragen.

**Revendications**

**1.** Circuit de commutation pour connecter un premier noeud de circuit (1) à un second ou à un troisième noeud de circuit (2, 3) conformément au potentiel de ce dernier, pour commander le potentiel d'une région d'isolation d'un circuit intégré en fonction du potentiel du substrat, comprenant un premier transistor bipolaire (T1) du type NPN avec le collecteur connecté audit premier noeud (1) et l'émetteur connecté audit second noeud (2), un second transistor bipolaire (T2) du type NPN avec le collecteur connecté audit premier noeud (1) et l'émetteur connecté audit troisième noeud (3), et des moyens (D1, T5, T6) destinés à maintenir la base dudit second transistor (T2) à une tension de polarisation préréglée constante, dans lequel lesdits trois noeuds de circuit (1, 2, 3) font partie d'un circuit intégré comprenant un substrat (53), un dispositif de puissance (Q1) avec le collecteur coïncidant avec ledit substrat (53) et constituant ledit troisième noeud (3) et un dispositif de commande du dispositif de puissance logé dans une région d'isolation (5) constituant ledit premier noeud (1), le second noeud (2) étant constitué par une connexion à la masse, lesdits premier et second transistors (T1, T2) du circuit de commutation connectant la région d'isolation (5) du circuit intégré, alternativement, au substrat (53) ou à la masse, selon la valeur de la tension prise par le substrat (53) du circuit intégré et, donc, par le collecteur du dispositif de puissance (Q1).

**2.** Circuit de commutation selon la revendication 1, caractérisé en ce que lesdits moyens (D1, T5, T6) destinés à maintenir la base dudit second transistor (T2) à une tension de polarisation préréglée constante sont constitués de moyens formant diode (D1) interposés entre la base dudit second transistor (T2) et la masse.

**3.** Circuit de commutation selon la revendication 1, caractérisé en ce que la base dudit second transistor bipolaire (T2) est connectée à l'émetteur d'un transistor bipolaire supplémentaire (T4) du type NPN avec le collecteur connecté à une alimentation ayant une tension (Vcc) et l'émetteur connecté à la masse à travers une résistance (R3), lequel transistor supplémentaire (T4) est destiné à commander ledit second transistor (T2) afin d'augmenter son gain.

**4.** Circuit de commutation selon la revendication 3, caractérisé en ce que lesdits moyens (D1, T5, T6) destinés à maintenir la base du second transistor (T2) à une tension de polarisation préréglée constante sont constitués par deux transistors bipolaires (T5, T6) du type NPN agencés en cascade entre la base dudit transistor supplémentaire (T4) et la masse, dont le premier (T5) est monté en diode.

**5.** Circuit de commutation selon la revendication 3, caractérisé en ce que ladite résistance (R3) est remplacée par une diode (D2).

**6.** Circuit de commutation selon la revendication 3, caractérisé en ce que ladite résistance (R3) est remplacée par la mise en série d'une diode (D2) et d'une résistance (R4) ayant une valeur faible.

**7.** Circuit de commutation selon la revendication 1, caractérisé en ce que la base dudit premier transistor (T1) est connectée au collecteur d'un troisième transistor bipolaire (T3 du type NPN avec l'émetteur connecté au troisième noeud de circuit (3) et avec la base connectée à la base dudit second transistor (T2), ledit troisième transistor (T3) étant destiné à entrer en saturation lorsque la tension du troisième noeud (3) est inférieure ou égale à zéro abaissant le potentiel de la base dudit premier transistor (T1) à des valeurs inférieures ou égales à zéro et, donc, l'interdisant.

8. Circuit de commutation selon la revendication 7, caractérisé en ce que lesdits second et troisième transistors (T2, T3) sont réalisés pour supporter des tensions inverses base/émetteur de l'ordre de 500 volts.

Fig.1

Fig.2

## Fig.3

## Fig.4

Fig.5

Fig.6

EP 0 520 125 B1

T10

T11

12  13  14

p+  n

p  p  p  n++  6  p+  p  n+  n++  p+

8  9  10  7

TP9  n+  n  11  n+  5

n−  TP8  p  TP7  p

4

n+

53

Fig.7

Fig.8

Fig.9

EP 0 520 125 B1

Fig.10